# EUROPEAN PATENT SPECIFICATION

(11) **EP 4 117 083 B1**
(45) Date of publication and mention of the grant of the patent: **22.04.2026**
(21) Application number: 21923464.8
(22) Date of filing: 29.12.2021
(51) Int. Cl.: H01M 10/44, H01M 50/204, H02J 7/00, G01R 31/385, H01M 4/04, H01M 10/46, H01M 10/625, H01M 10/647, H01M 10/655, G01R 31/36, H01M 10/48, H01M 10/613, H01M 10/617, H01M 10/63, H01M 10/653, H01M 10/6555, H01M 10/6563

(54) **SECONDARY BATTERY CHARGING/DISCHARGING SYSTEM INCLUDING INSULATION PAD, AND METHOD FOR CONTROLLING TEMPERATURE OF SECONDARY BATTERY CHARGING/DISCHARGING SYSTEM BY USING SAME**
SEKUNDÄRBATTERIELADE-/-ENTLADESYSTEM MIT ISOLIERPAD UND VERFAHREN ZUR STEUERUNG DER TEMPERATUR EINES SEKUNDÄRBATTERIELADE-/-ENTLADESYSTEMS DAMIT
SYSTÈME DE CHARGE/DÉCHARGE DE BATTERIE SECONDAIRE COMPRENANT UN TAMPON ISOLANT, ET PROCÉDÉ DE COMMANDE DE LA TEMPÉRATURE D'UN SYSTÈME DE CHARGE/DÉCHARGE DE BATTERIE SECONDAIRE À L'AIDE DE CELUI-CI

(30) Priority: 28.01.2021 KR 20210012099
(43) Date of publication of application: 11.01.2023
(73) Proprietor: LG Energy Solution, Ltd., Seoul 07335 (KR)
(72) Inventor: GU, Ja Eon, Daejeon 34122 (KR); KIM, Dong Yeon, Daejeon 34122 (KR); KONG, Jin Hak, Daejeon 34122 (KR)
(74) Representative: Goddar, Heinz J.
(86) International application number: PCT/KR2021/020206
(87) International publication number: WO 2022/164058

(56) References cited:
- EP-A1- 2 911 233
- WO-A1-2015/015649
- JP-A- 2019 083 150
- JP-A- H07 192 774
- JP-B2- 5 401 900
- KR-A- 20200 062 176
- KR-A- 20200 078 207
- KR-B1- 101 606 961
- KR-B1- 101 816 843
- US-A1- 2012 177 968

## Description

### [Technical Field]

The present invention relates to a secondary battery charging and discharging system including an insulation pad and a temperature control method of a secondary battery charging and discharging system using the same.

### [Background Art]

Recently, as the technology development and the demand for mobile devices increase, the demand for secondary batteries as energy sources is rapidly increasing.

According to types of external device, a secondary battery may be used in the form of a single battery cell or in the form of a battery module in which a plurality of unit cells are electrically connected. For example, a small device such as a mobile phone can operate for a predetermined time using the output power and capacity of one battery cell, whereas medium or large devices, such as notebook computers, portable digital versatile discs (DVDs), small personal computers (PCs), electric vehicles, and hybrid electric vehicles, require the use of a battery module including a plurality of battery cells due to a problem of output power and a capacity.

Meanwhile, a secondary battery is manufactured through a process of assembling a battery cell and a process of activating the secondary battery. In this case, the process of activating the secondary battery is usually performed such that a charging and discharging device including positive and negative contact pins applies a required current to the battery cell which is a charging and discharging target.

The conventional secondary battery charging and discharging system includes a tray for accommodating a plurality of battery cells, a charging and discharging part having a structure which is capable of being in electrical contact with first and second electrode leads protruding from the battery cells accommodated in the tray, and a cooling part provided to dissipate heat generated from the battery cells in a process in which the battery cells are repeatedly charged and discharged to be activated.

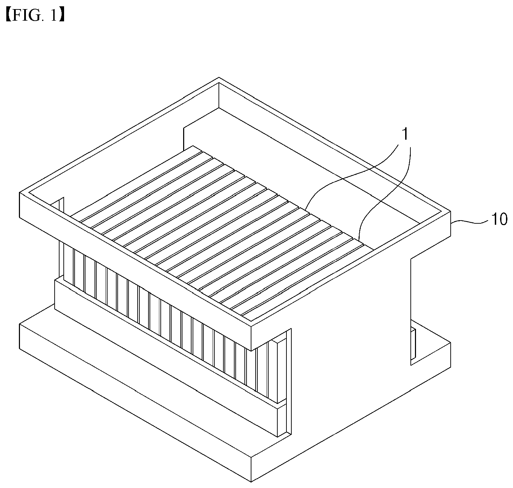

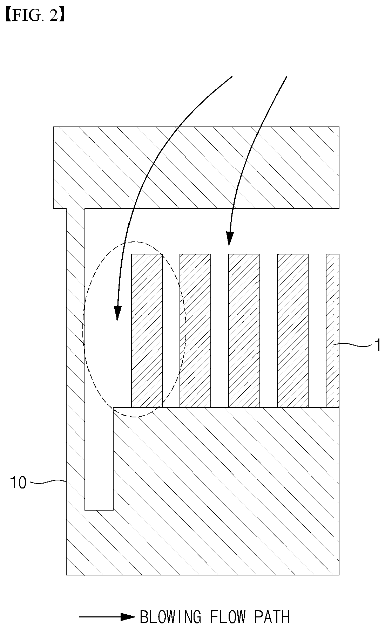

FIG. 1 is a diagram illustrating a tray of a conventional secondary battery charging and discharging system, and FIG. 2 is a schematic diagram illustrating a blowing path of cooled air between battery cells accommodated in the tray of the conventional secondary battery charging and discharging system.

As shown in FIGS. 1 and 2, a plurality of battery cells are accommodated in the tray of the secondary battery charging and discharging system. Although not shown in FIGS. 1 and 2, in the secondary battery charging and discharging system, a cooling part of a tray 10 includes a blowing fan for supplying cooled air toward the tray 10 in which a plurality of battery cells 1 are accommodated. However, according to positions of the battery cells 1 accommodated in the tray 10, a temperature deviation is present in the plurality of battery cells 1. **In** particular, since an area in contact with the cooled air is large, a temperature of a battery cell 1, which is disposed at an outermost position, among the plurality of battery cells 1 accommodated in the tray 10 is lowest.

Meanwhile, when a temperature deviation is present in a plurality of battery cells in a process of charging or discharging a battery cell, a capacity deviation of the battery cell may also occur. Accordingly, when it is necessary to determine whether the battery cell is defective on the basis of a measured value of a capacity of the battery cell in the process of charging or discharging the battery cell, a problem in that selectivity for determining whether the battery cell is defective is degraded may occur.

Therefore, there is a need to develop a technology for a secondary battery charging and discharging system capable of addressing a temperature deviation between battery cells when a plurality of battery cells are charged and discharged in the process of activating a secondary battery.

The document EP 2 911 233 Al discloses a battery block comprising a plurality of battery cells arranged with spacers and end plates.

The document JP 2019 083150 A discloses a heat insulating sheet having an insulating layer and heat absorbing layers for a battery pack.

The document KR 101 816 843 B1 discloses a cooling device for charging and discharging provided in a battery module.

The document JP 5 401900 B2 discloses a battery temperature control device for battery cells by means of a temperature control medium.

The document US 2012/177968 A1 discloses a battery pack in which a plurality of battery cells are coupled by thermally conductive material, optionally with a circulation device or thermal insulator, to dissipate heat between the cells.

### [Disclosure]

### [Technical Problem]

An abject of the present invention is to provide a secondary battery charging and discharging system including an insulation pad capable of addressing a temperature deviation of a plurality of battery cells in a process of activating the secondary battery, and a temperature control method of a secondary battery charging and discharging system using the same.

### [Technical Solution]

The present invention provides a secondary battery charging and discharging system. One aspect of the present invention provides the secondary battery charging and discharging system including a tray configured to accommodate a plurality of battery cells, an insulation pad disposed in the tray, the insulation pad being disposable between the tray and an outermost battery cell among the plurality of battery cells so as to be contactable with one surface of the outermost battery cell, a charging and discharging part configured to be electrically connected to first and second electrode leads of the plurality of battery cells accommodated in the tray, and a cooler configured to cool the plurality of battery cells accommodated in the tray.

The insulation pad may include at least one material of nitrile butadiene rubber, natural rubber, fluorine rubber, high-cis polybutadiene rubber (HBR), styrene butadiene rubber, chloroprene rubber, ethylene propylene rubber (ethylene propylene terpolymers (EPDM)), or silicone rubber.

An average thickness of the insulation pad may range from 1 mm to 20 mm, and the insulation pad may be configured to be in contact with 80% or more of an area of the one surface of the outermost battery cell.

In the secondary battery charging and discharging system, heat sink pads are disposed in the tray. In a specific example, the heat sink pads are disposed such that three to ten battery cells of the plurality of battery cells are interposable therebetween.

The cooler of the secondary battery charging and discharging system may include a blowing fan located above the tray, and n perforated plates located on a blowing path from the blowing fan, where n is an integer greater than or equal to two, and the perforated plates define a stacked structure.

The secondary battery charging and discharging system may further include a sensor configured to measure an inner temperature of the secondary battery charging and discharging system and may further include a controller configured to receive the inner temperature of the secondary battery charging and discharging system measured by the sensor and to control driving of the cooler.

The plurality of battery cells accommodated in the tray of the secondary battery charging and discharging system may be vertically arranged. In addition, the tray may have a structure in which a side surface is open. The cooler may include a sub blowing fan configured to blow cooled air from a side surface of the tray to the plurality of battery cells.

The cooler may include a blowing fan located above the tray, and a sub blowing fan configured to blow cooled air from a side surface of the tray to the plurality of battery cells.

Another aspect of the present invention provides a temperature control method of a secondary battery charging and discharging system that uses the above-described secondary battery charging and discharging system. In one example, the temperature control method of a secondary battery charging and discharging system includes charging and discharging a battery cell accommodated in the tray.

In this case, the charging and discharging of the battery cell may include measuring an inner temperature of the secondary battery charging and discharging system in the charging and discharging of the battery cell, and controlling, by a controller, the cooler according to the measured inner temperature of the secondary battery charging and discharging system.

### [Advantageous Effects]

In accordance with a secondary battery charging and discharging system including an insulation pad and a temperature control method of a secondary battery charging and discharging system using the same according to the present invention, it is possible to minimize a temperature deviation between a plurality of battery cells disposed in a tray.

### [Brief Description of the Drawings]

FIG. 1 is a diagram illustrating a tray of a conventional secondary battery charging and discharging system.
FIG. 2 is a schematic diagram illustrating a blowing path of cooled air between battery cells accommodated in the tray of the conventional secondary battery charging and discharging system.
FIG. 3 is a schematic diagram illustrating a secondary battery charging and discharging system according to one embodiment of the present invention.
FIGS. 4 and 5 are schematic diagrams illustrating a tray of the secondary battery charging and discharging system according to one embodiment of the present invention.
FIG. 6 shows graphs showing measured temperatures according to positions of battery cells accommodated in a tray when a secondary battery charging and discharging system according to a first embodiment of the present invention and the conventional secondary battery charging and discharging system are used.
FIG. 7 is a schematic diagram illustrating temperature distributions when the secondary battery charging and discharging system according to the first embodiment of the present invention and the conventional secondary battery charging and discharging system are used.
FIG. 8 is a schematic diagram illustrating a tray of a secondary battery charging and discharging system according to another embodiment of the present invention.
FIG. 9 is a schematic diagram illustrating a secondary battery charging and discharging system according to still another embodiment of the present invention.
FIG. 10 is a schematic diagram illustrating a secondary battery charging and discharging system according to yet embodiment of the present invention.
FIG. 11 is a flowchart illustrating a temperature control method of a secondary battery charging and discharging system according to one embodiment of the present invention.

### [Detailed Description of the Preferred Embodiments]

Hereinafter, the present invention will be described in detail. Before describing the present invention, terms or words used herein and the appended claims should not be construed to be limited to ordinary or dictionary meanings, and, these should be construed in accordance with the meaning and concept consistent with the present invention according to the principle in that inventors can properly define concepts of terms in order to describe their inventions in the best way.

In the present application, the terms "comprising," "having," or the like are used to specify that a feature, a number, a step, an operation, a component, an element, or a combination thereof described herein is present, and the terms do not preclude the presence or addition of one or more other features, numbers, steps, operations, components, elements, or combinations thereof. In addition, when a portion of a layer, a film, a region, a plate, or the like is referred to as being "on" another portion, this includes not only a case in which the portion is "directly on" another portion but also a case in which still another portion is present between the portion and the other portion. Contrarily, when a portion of a layer, a film, a region, a plate, or the like is referred to as being "under" another portion, this includes not only a case in which the portion is "directly under" another portion but also a case in which still another portion is present between the portion and another portion. In addition, in the present application, being disposed "on" may include the case of being disposed not only on an upper portion but also on a lower portion.

The present invention relates to a secondary battery charging and discharging system including an insulation pad and a temperature control method of a secondary battery charging and discharging system using the same.

**In** a conventional secondary battery charging and discharging system, a cooling part is used to dissipate the overall heat of a plurality of battery cells accommodated in a tray. Thus, a temperature deviation is present in the plurality of battery cells accommodated in the tray according to positions of the plurality of accommodated battery cells. **In** particular, since an area in contact with air blown from a cooling part is large, a temperature of a battery cell, which is disposed at the outermost position among the plurality of battery cells accommodated in the tray, is lowest. However, when it is necessary to determine whether the battery cell is defective on the basis of a measured value of a capacity of the battery cell in a process of charging or discharging the battery cell, a problem in that selectivity for determining whether the battery cell is defective is degraded may occur.

Thus, the present invention provides a secondary battery charging and discharging system including an insulation pad and a temperature control method of a secondary battery charging and discharging system using the same. **In** particular, in the secondary battery charging and discharging system according to the present invention, the insulation pad is disposed in contact with one surface of an outermost battery cell among the plurality of battery cells accommodated in the tray. The insulation pad may prevent the transfer of heat from one surface of the outermost battery cell, thereby preventing a temperature of the outermost battery cell from rapidly dropping during an operation of the cooling part of the secondary battery charging and discharging system. Therefore, the secondary battery charging and discharging system according to the present invention can minimize a temperature deviation between the plurality of battery cells disposed in the tray.

### [Modes of the Invention]

Hereinafter, a secondary battery charging and discharging system and a temperature control method of a secondary battery charging and discharging system using the same according to the present invention will be described in detail with reference to the accompanying drawings.

### < First Embodiment>

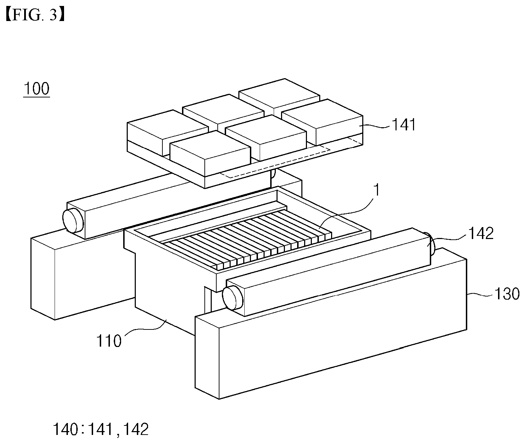

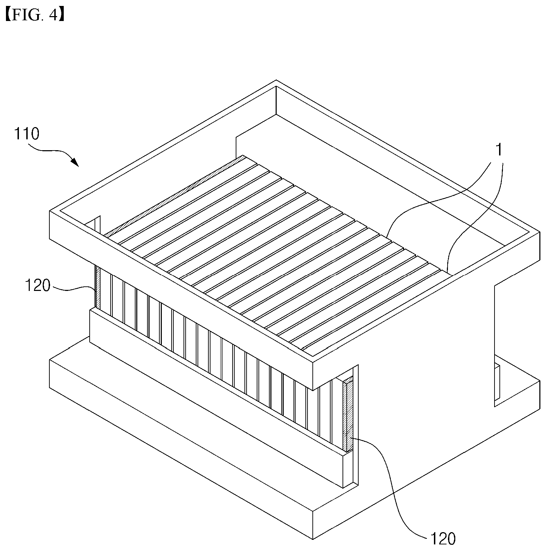

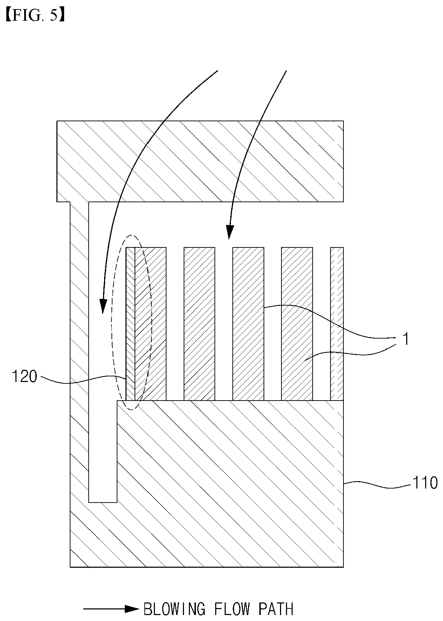

FIG. 3 is a schematic diagram illustrating a secondary battery charging and discharging system according to one embodiment of the present invention, and FIGS. 4 and 5 are schematic diagrams illustrating a tray of the secondary battery charging and discharging system according to one embodiment of the present invention.

Referring to FIGS. 3 to 5, the secondary battery charging and discharging system 100 according to the present invention includes a tray 110 which accommodates a plurality of battery cells 1, an insulation pad 120 disposed in the tray 110 and disposed between an outermost battery cell 1 among the plurality of battery cells 1 and the tray 110, a charging and discharging part 130 electrically connected to first and second electrode leads (not shown) formed in the plurality of battery cells 1 accommodated in the tray 110, and a cooling part 140 for cooling the plurality of battery cells 1 accommodated in the tray 110.

In this case, the insulation pad 120 may be disposed e in contact with one surface of the outermost battery cell 1.

For example, the insulation pads 120 are disposed in contact with an outer surface of a battery cell 1 firstly disposed among the plurality of battery cells 1 accommodated in the tray 110 and disposed in contact with an outer surface of a battery cell 1 lastly disposed thereamong. With the above configuration, the insulation pad 120 may block a flow path of cooled air supplied from the cooling part 140, thereby preventing the movement of heat radiated from the battery cell 1 disposed at the outermost position. Accordingly, when the cooling part 140 of the secondary battery charging and discharging system 100 is operated, it is possible to prevent a temperature of the outermost battery cell 1 from dropping rapidly and is possible to minimize a temperature deviation between the plurality of battery cells 1.

In one example, the insulation pad 120 is for preventing the movement of heat and may be made of a material with low thermal conductivity. The insulation pad 120 may be made of rubber with low thermal conductivity, and in addition to the rubber, the insulation pad 120 may be made of a glass fiber or a foamed plastic material. In a specific example, the insulation pad 120 may be made of one or more selected from the group consisting of nitrile butadiene rubber, natural rubber, fluorine rubber, high-cis polybutadiene rubber (HBR), styrene butadiene rubber, chloroprene rubber, ethylene propylene rubber (ethylene propylene terpolymers (EPDM)), and silicone rubber. For example, the insulation pad 120 may be made of nitrile butadiene rubber.

In one example, the insulation pad 120 has an average thickness ranging from 1 mm to 20 mm. In a specific example, the average thickness of the insulation pad 120 may range from 1 mm to 20 mm, from 1 mm to 10 mm, from 2 mm to 10 mm, or from 2 mm to 5 mm. When a thickness of the insulation pad 120 is less than 1 mm, the thickness is too small so that durability may not be good and an insulation effect may also be degraded. In addition, when the thickness of the insulation pad 120 exceeds 20 mm, it is possible to prevent a temperature of the outermost battery cell 1 from dropping rapidly, but the thickness of the insulation pad 120 is too thick such that space efficiency may be degraded.

In addition, the insulation pad 120 may have a structure in which the insulation pad 120 is in contact with an area of 80% or more of one side of the battery cell 1. For example, the insulation pad 120 may have a structure in contact with an entire area of one side of the battery cell 1. The reason is to effectively prevent the transfer of heat. When the insulation pad 120 is in contact with an area of less than 80% of the outermost battery cell 1 with respect to the area of one side of the outermost battery cell 1, since an area in contact with air blown from the cooling part 140 is large, a temperature of the outermost battery cell 1 may be lower than temperatures of the remaining battery cells 1 disposed in other regions. Accordingly, the insulation pad 120 and the battery cell 1 may have the above-described contact area.

In one example, the tray 110 of the secondary battery charging and discharging system 100 according to the present invention is a substantially quadrangular box-shaped member with an open upper portion and accommodates the plurality of battery cells 1 which are disposed and mounted in the form of a matrix.

In addition, the tray 110 may have a structure in which both side surfaces are perforated to allow the first and second electrode leads of the accommodated battery cells 1 to protrude. In a specific example, since both of the side surfaces of the tray 110 are perforated, the first and second electrode leads of the battery cell 1 accommodated in the tray 110 may be connected to an external unit. For example, the first and second electrode leads of the battery cell 1 accommodated in the tray 110 may be electrically connected to the charging and discharging part 130 which will be described below.

In one example, the charging and discharging part 130 is located on each of two side surfaces of the tray 110 and is electrically connected to the first and second electrode leads of the plurality of battery cells 1 accommodated in the tray 110. The charging and discharging part 130 may activate the battery cell 1 through charging and discharging of an electrode assembly of the battery cell 1 electrically connected to the charging and discharging part 130. In this case, the charging and discharging part 130 is electrically connected to an electrode lead of the battery cell 1 through a charging and discharging line. The charging and discharging part 130 may supply charging power to the battery cell 1 or receive discharging power from the battery cell 1. Here, the supply of the charging power to the battery cell 1 is not necessarily limited to the meaning of the supply of sufficient power to fully charge the battery cell 1. The supply of the charging power to the battery cell 1 may be used to mean the supply of sufficient power to measure voltages of the first electrode lead and the second electrode lead for performance evaluation of a secondary battery. Similarly, the meaning of the reception of the discharging power from the battery cell 1 may be used so that a duplicate description will be omitted herein.

Meanwhile, the charging and discharging part 130 may be coupled to the plurality of battery cells 1 accommodated in the tray 110 to supply power and may charge and discharge the plurality of battery cells 1 at a set charge and discharge time, a set voltage, and a set number of times.

In one example, the secondary battery charging and discharging system 100 according to the present invention includes the cooling part 140 for cooling the plurality of battery cells 1 accommodated in the tray 110. In a specific example, in the secondary battery charging and discharging system 100, when a temperature of the battery cell 1 exceeds, e.g., 40 °C while the battery cell 1 is charged or discharged, the efficiency or performance of the battery cell 1 may be degraded, durability may be degraded, and a thermal risk (e.g., damage to parts, explosion, or the like) may be increased. Thus, heat generated during a charging and discharging process of the battery cell 1 should be dissipated to reduce the temperature of the battery cell 1 using the cooling part 140 according to the present invention. In addition, in a process of dissipating heat during the charging and discharging process of the battery cell 1, the same plurality of battery cells 1 may uniformly or equally emit heat and a temperature deviation may be reduced as much as possible. This is because, when the temperature deviation between the battery cells is large, the efficiency, stability, and durability of the battery cell 1 may be affected.

In one example, the plurality of battery cells 1 accommodated in the tray 110 has a vertically arranged structure, and the cooling part 140 blows air of a downward airflow through a blowing fan 141 located above the tray 110.

In addition, the secondary battery charging and discharging system 100 according to the present invention may include sub blowing fans 142. In a specific example, the sub blowing fans 142 may blow cooled air from the side surface of the tray 110 toward the battery cell 1. The sub blowing fans 142 may be installed opposite to each other on both sides of the tray 110 to guide air in a direction parallel to the plurality of battery cells 1.

Meanwhile, the plurality of battery cells 1 accommodated in the tray 110 may refer to two to thirty arranged battery cells 1, five to twenty arranged battery cells 1, or ten to sixteen arranged battery cells 1.

In one example, the plurality of battery cells 1 accommodated in the tray 110 may be pouch-type battery cells. In a specific example, the battery cell 1 is a pouch-type unit cell in which an electrode assembly having a positive electrode/separator/negative electrode structure is embedded in a laminate sheet exterior material in a state of being connected to electrode leads formed outside of the exterior material. The electrode leads may be drawn out of a sheet and may extend in the same direction or opposite directions.

Although the leads are not shown in the drawings of the present invention for convenience of illustration, a pair of leads may be in the form of being drawn out in opposite directions or in the same direction.

### <Experimental Example>

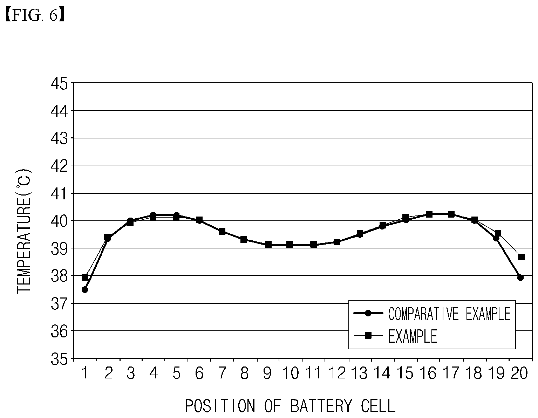

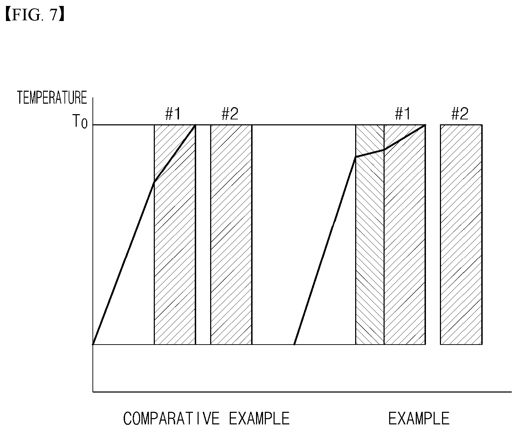

When a secondary battery charging and discharging system according to a first embodiment of the present invention and the conventional secondary battery charging and discharging system were applied, temperatures according to positions of the battery cells accommodated in the tray were measured. Meanwhile, in an experimental example of the present invention, an insulation pad made of a rubber material with a thickness of 3 mm was disposed in contact with one surface of the battery cell, and then the secondary battery charging and discharging system was operated. In addition, the results of the operation were shown in FIGS. 6 and 7.

FIG. 6 shows graphs showing measured temperatures according to positions of the battery cells accommodated in the tray when the secondary battery charging and discharging system according to the first embodiment of the present invention and the conventional secondary battery charging and discharging system are used, and FIG. 7 is a schematic diagram illustrating temperature distributions when the secondary battery charging and discharging system according to the first embodiment of the present invention and the conventional secondary battery charging and discharging system are used.

Referring to FIGS. 6 and 7, in the case of the conventional secondary battery charging and discharging system, a measured temperature of a battery cell located at the outermost portion of the tray was 37 °C, and a temperature of a battery cell located in a central region was about 40 °C. That is, the temperatures of the battery cells were different according to the position in the tray, and a large temperature deviation was exhibited. On the other hand, according to the battery charging/discharging system of the present invention, a difference in temperature between 20 battery cells accommodated in the tray was small. In particular, the measured temperature of the battery cell located at the outermost position of the tray was about 38.5 °C, and a temperature deviation between the battery cell located at the outermost position and the battery cell located in the central region was not large.

Since the insulation pad is provided on one surface of the outermost battery cell and prevents the movement of heat, it is determined that the temperature of the outermost battery cell can be prevented from dropping rapidly when the cooling part of the secondary battery charging and discharging system is operated.

Therefore, the secondary battery charging and discharging system according to the present invention can minimize a temperature deviation between the plurality of battery cells disposed in the tray.

### <Second Embodiment>

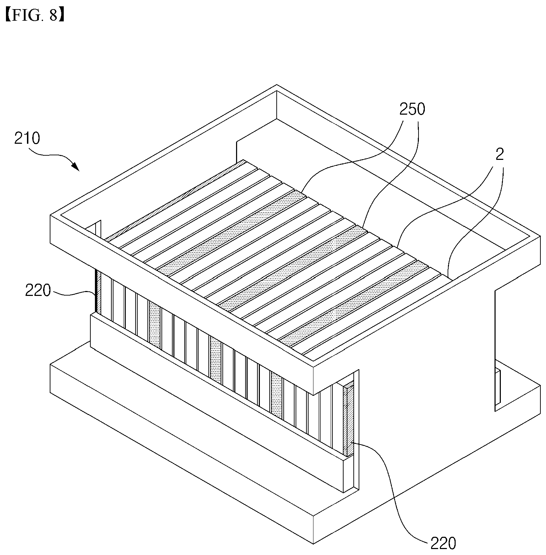

FIG. 8 is a schematic diagram illustrating a tray of a secondary battery charging and discharging system according to another embodiment of the present invention. Referring to FIG. 8, in a secondary battery charging and discharging system 200 according to the present invention, heat sink pads 250 are additionally disposed between a plurality of battery cells 2 in a tray 210. In a specific example, the heat sink pads 250 are disposed with three to ten battery cells 2 interposed therebetween. For example, the heat sink pads 250 may be disposed with four battery cells 2 interposed therebetween.

In the conventional secondary battery charging and discharging system, since an area of a battery cell 2, which is disposed at the outermost position among the plurality of battery cells 2 accommodated in the tray 210, in contact with air blown from a cooling part is large, a temperature of the battery cell 2 is low and a temperature of a battery cell 2 in a central portion is high. Accordingly, in the present invention, an insulation pad 220 is disposed in contact with one surface of the outermost battery cell 2 among the plurality of battery cells 2, and the heat sink pad 250 is disposed in a central portion among the plurality of battery cells 2 so that a difference in temperature between the plurality of battery cells 2 can be minimized.

Specifically, the insulation pad 220 blocks a flow path of the cooled air supplied from the cooling part to prevent the movement of heat radiated from the outermost battery cell 2 so that the temperature of the outermost battery cell 2 can be prevented from dropping rapidly. Further, since heat moves to battery cells 2 adjacent to each other through the heat sink pad 250, temperatures of the battery cells 2 can be properly maintained, and the temperature of the battery cell 2 disposed in the central portion can be prevented from rising.

The heat sink pad 250 may be made of any material having a property capable of promoting thermal conductivity between the battery cells 2. For example, the heat sink pad 250 may include a thermal interface material (TIM) such as thermal grease.

### <Third Embodiment>

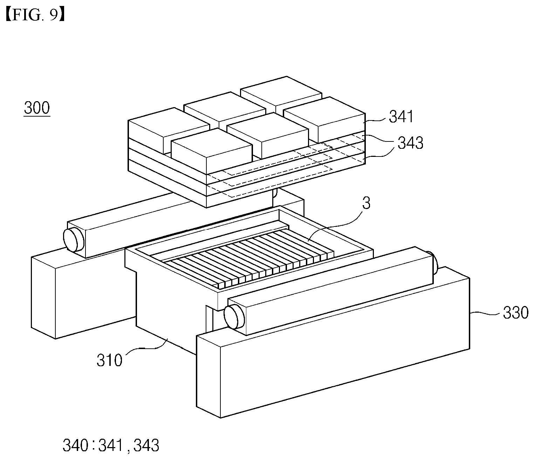

FIG. 9 is a schematic diagram illustrating a secondary battery charging and discharging system according to still another embodiment of the present invention. Referring to FIG. 9, in a secondary battery charging and discharging system 300 according to the present invention, a cooling part 340 guides air in a direction parallel to a plurality of battery cells 3 accommodated in a tray 310, thereby cooling the plurality of battery cells 3. In a specific example, the cooling part 340 includes a blowing fan 341 located above the tray 310, and n perforated plates 343 which are located on a blowing flow path by the blowing fan 341 and which form a stacked structure. Here, n is an integer of two or more.

The blowing fan 341 is a generally widely used propeller-type blowing fan 341 and is located above the tray 310. In addition, the blowing fan 341 is installed on the n perforated plates 343, which will be described below, and blows air downward. As described above, the air blown downward may flow into the tray 310 through an air flow path perforated in the perforated plate 343. In addition, the blowing fan 341 is provided as a plurality of blowing fans 341 that are equally divided and disposed above the tray 310. The cooling part 340 may include a structure in which two to five perforated plates 343 are stacked or include a structure in which three to five perforated plates 343 are stacked. For example, three perforated plates 343 may be stacked.

Meanwhile, the n perforated plates 343 serve to introduce the air blown by the blowing fan 341 into the inside of the tray 310. For example, the cooling part 340 includes three perforated plates 343, and thus the air blown by the blowing fan 341 passes through holes formed in the three perforated plates 343 so that the uniformity of a flow rate can be gradually achieved.

As described above, the perforated plate 343 has a structure in which a plurality of holes are formed, and the holes are formed in a central region of the perforated plate 343. In particular, with the above structure, when compared to the related art, since less cooled air is supplied in a direction in which a battery cell 3 accommodated in the outermost portion of the tray 310 is located, a temperature deviation between the battery cells 3 accommodated in the tray 310 may be balanced. Accordingly, the flow rate may be uniformly distributed so that the temperature deviation between the plurality of battery cells 3 can be minimized.

In another example, as described above, the perforated plate 343 has a structure in which a plurality of holes are formed, and a diameter of a hole formed in the central region of the perforated plate 343 may be larger than a diameter of a hole formed in an edge of the perforated plate 343. In a specific example, diameters of the holes formed in the perforated plate 343 are formed to be gradually smaller from the central region toward the edge. The structure is formed such that the air of the blowing fan 341 is supplied to the tray 310 in which the plurality of battery cells 3 are accommodated and an amount of the air supplied to the edge of the tray 310 is reduced.

In still another example, the perforated plate 343 may have a structure in which a plurality of slits are formed in parallel. The air supplied from the blowing fan 341 may flow into the tray 310 through the plurality of slits formed in the perforated plate 343. In a specific example, the slit has a structure formed in a direction parallel to the accommodation direction of the battery cell 3 accommodated in the tray 310 and, particularly, the slit may be formed in a central region of the perforated plate 343.

In yet another example, the perforated plate 343 has a structure in which a plurality of slits are formed in parallel. The air supplied from the blowing fan 341 may flow into the tray 310 through the plurality of slits formed in the perforated plate 343. In a specific example, the slit has a structure formed in a direction parallel to the accommodation direction of the battery cell 3 accommodated in the tray 310. Meanwhile, a width of a slit formed in the central region of the perforated plate 343 is larger than a width of a slit formed in the edge of the perforated plate 343. For example, the widths of the holes formed in the perforated plate 343 are formed to be gradually smaller from the central region toward the edge. The structure is formed such that the air of the blowing fan 341 is supplied to the tray 310 in which the plurality of battery cells 3 are accommodated and an amount of the air supplied to the edge of the tray 310 is reduced.

Meanwhile, the holes formed in the n number of perforated plates 343 may be formed to have different sizes and shapes for each layer. In a specific example, a plurality of holes may be formed in the central region of the perforated plate 343 located at the top, and a plurality of holes may be formed in an entire region of the perforated plate 343 located at the bottom. Meanwhile, sizes of the holes of the perforated plate 343 may be gradually decreased from the top to the bottom.

In particular, with the above structure, when compared to the related art, since less air is supplied in a direction in which a battery cell 3 accommodated in the outermost portion of the tray 310 is located, a temperature deviation between the battery cells 3 accommodated in the tray 310 may be balanced. Accordingly, the flow rate may be uniformly distributed so that the temperature deviation between the plurality of battery cells 3 can be minimized.

### <Fourth Embodiment>

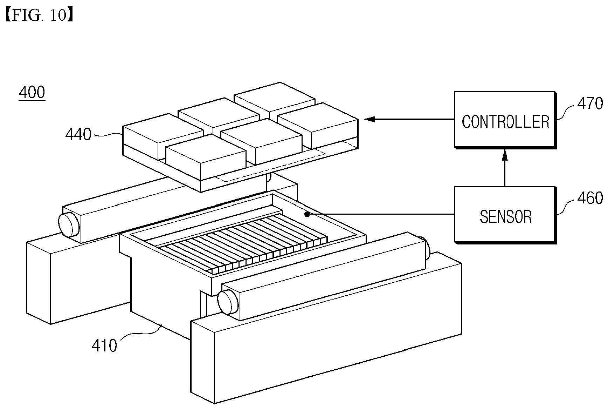

FIG. 10 is a schematic diagram illustrating a secondary battery charging and discharging system according to yet embodiment of the present invention. Referring to FIG. 10, a secondary battery charging and discharging system 400 according to the present invention includes a sensor 460 for measuring an inner temperature of the secondary battery charging and discharging system 400, and a controller 470 for receiving the inner temperature of the secondary battery charging and discharging system 400 measured by the sensor 460 and controlling the operation of a cooling part 440.

In a specific example, the sensor 460 is provided as a temperature sensor for sensing an inner temperature of the secondary battery charging and discharging system 400. In the present invention, the inner temperature of the secondary battery charging and discharging system 400 may refer to a temperature of an inner space of the secondary battery charging and discharging system 400 or may refer to a temperature of a battery cell 4. For example, the inner temperature of the secondary battery charging and discharging system 400 may refer to an inner temperature of the secondary battery charging and discharging system 400 during a charging/discharging process. As described above, when the temperature of battery cell 4 becomes too high during charging and discharging of the battery cell 4, the efficiency or performance of the battery cell 4 may be degraded and durability thereof may be reduced. To prevent the above problems, the temperature sensor may monitor the inner temperature of the secondary battery charging and discharging system 400 in real time and transmit the inner temperature to the controller 470, and the controller 470 may control whether to drive the cooling part 440.

Meanwhile, when a plurality of battery cells 4 are accommodated in the tray 410, a plurality of temperature sensors may also be provided. Furthermore, the sensor 460 may be a non-contact temperature sensor capable of detecting a surface temperature of battery cell 4.

When the inner temperature of the secondary battery charging and discharging system 400 is higher than a reference temperature, the controller 470 controls the cooling part 440 to be driven. In addition, when the inner temperature of the secondary battery charging and discharging system 400 measured by the sensor 460 is lower than the reference temperature, the controller 470 controls the operation of the cooling part 440 to be interrupted. As described above, the inner temperature of the secondary battery charging and discharging system 400 may refer to the temperature of the battery cell 4 accommodated in the tray 410.

For example, the controller 470 may set the reference temperature to 40 °C, and when the temperature of battery cell 4 is higher than 40 °C, the controller 470 operates the cooling part 440, and when the temperature of battery cell 4 is lower than 40 °C, the controller 470 interrupts the operation of the cooling part 440. Accordingly, since the cooling part 440 is driven according to the temperature of battery cell 4 of the secondary battery charging and discharging system 400, the temperature can be maintained more efficiently.

### <Fifth Embodiment>

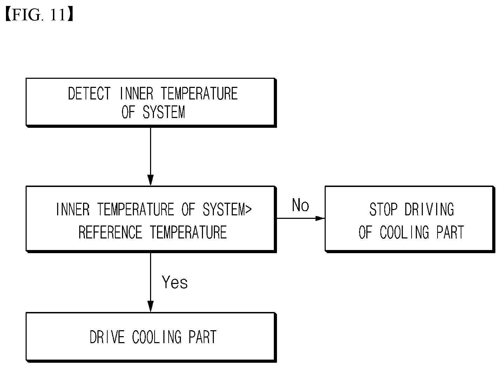

FIG. 11 is a flowchart illustrating a temperature control method of a secondary battery charging and discharging system according to one embodiment of the present invention. Referring to FIG. 11, the temperature control method of the secondary battery charging and discharging system according to the present invention includes charging and discharging a battery cell accommodated in an accommodation part. The charging and discharging of the battery cell includes measuring an inner temperature of the secondary battery charging and discharging system, and controlling whether to drive a cooling part according to the measured inner temperature of the secondary battery charging and discharging system.

As described above, the sensor performs the measuring of the inner temperature of the secondary battery charging and discharging system. In addition, the driving of the cooling part is controlled on the basis of the inner temperature of the secondary battery charging and discharging system measured by the sensor. That is, when the inner temperature of the secondary battery charging and discharging system is higher than the reference temperature, the cooling part is driven, and when the inner temperature of the secondary battery charging and discharging system is lower than the reference temperature, the driving of the cooling part is interrupted.

Here, the inner temperature of the secondary battery charging and discharging system refers to the inner temperature of the secondary battery charging and discharging system or the temperature of the battery cell accommodated in the accommodation part.

For example, the reference temperature may be set to 40 °C, and when the temperature of the battery cell is higher than 40 °C in the charging/discharging process, the cooling part is driven, and when the temperature of the battery cell is lower than 40 °C, the driving of the cooling part is interrupted. Accordingly, since the cooling part is driven according to the temperature of the battery cell in the charging/discharging process, the temperature can be maintained more efficiently.

In the temperature control method of a secondary battery charging and discharging system according to the present invention, an insulation pad in contact with one surface of an outermost battery cell is included in a tray to prevent the movement of heat on the one surface of the outermost battery cell so that, when the cooling part of the secondary battery charging and discharging system is operated, it is possible to prevent the temperature of the outermost battery cell from dropping rapidly. Therefore, the secondary battery charging and discharging system according to the present invention can minimize a temperature deviation between the plurality of battery cells disposed in the tray.

As described above, the present invention has been described in more detail with reference to the accompanying drawings and the embodiments. Therefore, the configurations described herein or shown in the drawings are merely one embodiment of the present invention. The invention is defined by the appended independent claims. The dependent claims showing different embodiments thereof.

### [Description of Reference Numerals]

1, 2, 3, 4: battery cells
100, 200, 300, 400: secondary battery charging and discharging systems
10, 110, 210, 310, 410: trays
120, 220: insulation pads
130, 330: charging and discharging parts
140, 340, 440: cooling parts
141, 341: blowing fans
142: sub blowing fan
250: heat sink pad
343: perforated plate
460: sensor
470: controller

## Claims

1. A secondary battery charging and discharging system (100, 200, 300, 400) comprising:
a tray (110, 210, 310, 410) configured to accommodate a plurality of battery cells (1, 2, 3, 4);
an insulation pad (120, 220) disposed in the tray (110, 210, 310, 410), the insulation pad (120, 220) being disposable between the tray (110, 210, 310, 410) and an outermost battery cell among the plurality of battery cells (1, 2, 3, 4) so as to be contactable with one surface of the outermost battery cell,
a charging and discharging part (310, 330) configured to be electrically connected to first and second electrode leads of the plurality of battery cells (1, 2, 3, 4) accommodated in the tray (110, 210, 310, 410);
a cooler (140, 340, 440) configured to cool the plurality of battery cells (1, 2, 3, 4) accommodated in the tray (110, 210, 310, 410); and
heat sink pads (250) disposed among the battery cells so that heat moves to the battery cells adjacent to each other through the heat sink pads (250)
wherein the heat sink pads (250) are disposed such that three to ten battery cells of the plurality of battery cells are interposable therebetween.

2. The secondary battery charging and discharging system of claim 1, wherein the insulation pad (120, 220) includes at least one material of nitrile butadiene rubber, natural rubber, fluorine rubber, high-cis polybutadiene rubber (HBR), styrene butadiene rubber, chloroprene rubber, ethylene propylene rubber (ethylene propylene terpolymers (EPDM)), or silicone rubber.

3. The secondary battery charging and discharging system of claim 1, wherein an average thickness of the insulation pad (120, 220) ranges from 1 mm to 20 mm.

4. The secondary battery charging and discharging system of claim 1, wherein the insulation pad (120, 220) is configured to be in contact with 80% or more of an area of the one surface of the outermost battery cell.

5. The secondary battery charging and discharging system of claim 1, wherein the cooler (140, 340, 440) includes:
a blowing fan (141, 341) located above the tray (110, 210, 310, 410); and
n perforated plates (343) located on a blowing path from the blowing fan (141, 341),
where n is an integer greater than or equal to two, and the perforated plates (343) define a stacked structure.

6. The secondary battery charging and discharging system of claim 1, further comprising a sensor (460) configured to measure an inner temperature of the secondary battery charging and discharging system.

7. The secondary battery charging and discharging system of claim 6, further comprising a controller (470) configured to:
receive the inner temperature of the secondary battery charging and discharging system measured by the sensor (460); and
control driving of the cooler (140, 340, 440).

8. The secondary battery charging and discharging system of claim 1, wherein the plurality of battery cells (1, 2, 3, 4) accommodated in the tray (110, 210, 310, 410) are vertically arranged.

9. The secondary battery charging and discharging system of claim 1, wherein the tray (110, 210, 310, 410) has a structure in which a side surface is open, and
wherein the cooler (140, 340, 440) includes a sub blowing fan (142) configured to blow cooled air from a side surface of the tray (110, 210, 310, 410) to the plurality of battery cells (1, 2, 3, 4).

10. A temperature control method of a secondary battery charging and discharging system that uses the secondary battery charging and discharging system (100, 200, 300, 400) of claim 1.

11. The temperature control method of claim 10, further comprising charging and discharging a battery cell accommodated in the tray (110, 210, 310, 410),
wherein the charging and discharging of the battery cell includes:
measuring an inner temperature of the secondary battery charging and discharging system (100, 200, 300, 400); and
controlling, by a controller (470), the cooler (140, 340, 440) according to the measured inner temperature of the secondary battery charging and discharging system (100, 200, 300, 400).

## Patentansprüche

1. Sekundärbatterie-Lade-und-Entladesystem (100, 200, 300, 400) aufweisend:
eine Ablageschale (110, 210, 310, 410), die konfiguriert ist, um mehrere Batteriezellen (1, 2, 3, 4) aufzunehmen;
ein Isolierpad (120, 220), das in der Ablageschale (110, 210, 310, 410) angeordnet ist, wobei das Isolierpad (120, 220) zwischen der Ablageschale (110, 210, 310, 410) und einer äußersten Batteriezelle unter den mehreren Batteriezellen (1, 2, 3, 4) angeordnet werden kann, um mit einer Oberfläche der äußersten Batteriezelle kontaktierbar zu sein,
ein Lade-und-Entladeteil (310, 330), das konfiguriert ist, mit einer ersten Elektrodenleitungund einer zweiten Elektrodenleitung der mehreren Batteriezellen (1, 2, 3, 4), die in der Ablageschale (110, 210, 310, 410) aufgenommen sind, elektrisch verbunden zu werden;
einen Kühler (140, 340, 440), der konfiguriert ist, die mehreren Batteriezellen (1, 2, 3, 4), die in der Ablageschale (110, 210, 310, 410) aufgenommen sind, zu kühlen; und
Wärmesenkenpads (250), die unter den Batteriezellen angeordnet sind, so dass Wärme durch die Wärmesenkenpads (250) an benachbarte Batteriezellen übertragen wird,
wobei die Wärmesenkenpads (250) so angeordnet sind, dass drei bis zehn Batteriezellen der mehreren Batteriezellen dazwischen platzierbar sind.

2. Sekundärbatterie-Lade-und-Entladesystem nach Anspruch 1, wobei das Isolierpad (120, 220) mindestens ein Material aus Nitrilbutadienkautschuk, Naturkautschuk, Fluorkautschuk, High-cis-Polybutadienkautschuk (HBR), Styrolbutadienkautschuk, Chloroprenkautschuk, Ethylenpropylenkautschuk (Ethylenpropylenterpolymere (EPDM)) oder Silikonkautschuk aufweist.

3. Sekundärbatterie-Lade-und-Entladesystem nach Anspruch 1, wobei eine durchschnittliche Dicke des Isolierpads (120, 220) im Bereich von 1 mm bis 20 mm liegt.

4. Sekundärbatterie-Lade-und-Entladesystem nach Anspruch 1, wobei das Isolierpad (120, 220) konfiguriert ist, um mit 80 % oder mehr einer Fläche der einen Oberfläche der äußersten Batteriezelle in Kontakt zu sein.

5. Sekundärbatterie-Lade-und-Entladesystem nach Anspruch 1, wobei der Kühler (140, 340, 440) aufweist:
ein Gebläse (141, 341), das über der Ablageschale (110, 210, 310, 410) angeordnet ist; und
n perforierte Platten (343), die auf einem Blaspfad von dem Gebläse (141, 341) angeordnet sind,
wobei n eine ganze Zahl größer oder gleich zwei ist und die perforierten Platten (343) eine gestapelte Struktur definieren.

6. Sekundärbatterie-Lade-und-Entladesystem nach Anspruch 1, ferner aufweisend einen Sensor (460), der konfiguriert ist, um eine Innentemperatur des Sekundärbatterie-Lade-und-Entladesystems zu messen.

7. Sekundärbatterie-Lade-und-Entladesystem nach Anspruch 6, ferner aufweisend eine Steuerung (470), die konfiguriert ist, um:
die durch den Sensor (460) gemessene Innentemperatur des Sekundärbatterie-Lade-und-Entladesystems zu empfangen; und
den Antrieb des Kühlers (140, 340, 440) zu steuern.

8. Sekundärbatterie-Lade-und-Entladesystem nach Anspruch 1, wobei die mehreren Batteriezellen (1, 2, 3, 4), die in der Ablageschale (110, 210, 310, 410) aufgenommen sind, vertikal angeordnet sind.

9. Sekundärbatterie-Lade-und-Entladesystem nach Anspruch 1, wobei die Ablageschale (110, 210, 310, 410) eine Struktur aufweist, in der eine Seitenfläche offen ist, und
wobei der Kühler (140, 340, 440) ein Subgebläse (142) aufweist, das konfiguriert ist, um gekühlte Luft von einer Seitenfläche der Ablageschale (110, 210, 310, 410) zu den mehreren Batteriezellen (1, 2, 3, 4) zu blasen.

10. Temperatursteuerverfahren eines Sekundärbatterie-Lade-und-Entladesystems, das das Sekundärbatterie-Lade-und-Entladesystem (100, 200, 300, 400) nach Anspruch 1 verwendet.

11. Temperatursteuerverfahren nach Anspruch 10, ferner umfassend Laden und Entladen einer Batteriezelle, die in der Ablageschale (110, 210, 310, 410) aufgenommen ist,
wobei das Laden und Entladen der Batteriezelle umfasst:
Messen einer Innentemperatur des Sekundärbatterie-Lade-und-Entladesystems (100, 200, 300, 400); und
Steuern, durch eine Steuerung (470), des Kühlers (140, 340, 440) gemäß der gemessenen Innentemperatur des Sekundärbatterie-Lade-und-Entladesystems (100, 200, 300, 400).

## Revendications

1. Système de charge et décharge de batterie rechargeable (100, 200, 300, 400) comprenant :
un plateau (110, 210, 310, 410) configuré pour loger une pluralité d'éléments de batterie (1, 2, 3, 4) ;
un tampon isolant (120, 220) disposé dans le plateau (110, 210, 310, 410), le tampon isolant (120, 220) pouvant être disposé entre le plateau (110, 210, 310, 410) et un élément de batterie le plus extérieur de la pluralité d'éléments de batterie (1, 2, 3, 4) de façon à pouvoir être en contact avec une surface de l'élément de batterie le plus extérieur,
une partie de charge et décharge (310, 330) configurée pour être connectée électriquement aux premier et deuxième câbles d'électrode de la pluralité d'éléments de batterie (1, 2, 3, 4) logés dans le plateau (110, 210, 310, 410) ;
un refroidisseur (140, 340, 440) configuré pour refroidir la pluralité d'éléments de batterie (1, 2, 3, 4) logés dans le plateau (110, 210, 310, 410) ; et
des tampons de dissipateur thermique (250) disposés parmi les éléments de batterie, de telle sorte que la chaleur se déplace vers les éléments de batterie adjacents l'un à l'autre par les tampons de dissipateur thermique (250)
dans lequel les tampons de dissipateur thermique (250) sont disposés de telle sorte que trois à dix éléments de batterie de la pluralité d'éléments de batterie peuvent être interposés entre eux.

2. Système de charge et décharge de batterie rechargeable selon la revendication 1, dans lequel le tampon isolant (120, 220) inclut un ou plusieurs matériaux parmi le caoutchouc de butadiène nitrile, caoutchouc naturel, caoutchouc fluoré, caoutchouc de polybutadiène haute teneur en cis (HBR), caoutchouc de butadiène styrène, caoutchouc de chloroprène, caoutchouc de propylène éthylène (terpolymères de propylène éthylène (EPDM)) ou caoutchouc de silicone.

3. Système de charge et décharge de batterie rechargeable selon la revendication 1, dans lequel une épaisseur moyenne du tampon isolant (120, 220) est dans la plage de 1 mm à 20 mm.

4. Système de charge et décharge de batterie rechargeable selon la revendication 1, dans lequel le tampon isolant (120, 220) est configuré pour être en contact avec 80 % ou plus d'une zone de ladite surface de l'élément de batterie le plus extérieur.

5. Système de charge et décharge de batterie rechargeable selon la revendication 1, dans lequel le refroidisseur (140, 340, 440) inclut :
un ventilateur de soufflage (141, 341) situé au-dessus du plateau (110, 210, 310, 410) ; et
n plaques perforées (343) situées sur un trajet de soufflage du ventilateur de soufflage (141, 341),
où n est un nombre entier égal ou supérieur à deux, et les plaques perforées (343) définissent une structure empilée.

6. Système de charge et décharge de batterie rechargeable selon la revendication 1, comprenant en outre un capteur (460) configuré pour mesurer une température intérieure du système de charge et décharge de batterie rechargeable.

7. Système de charge et décharge de batterie rechargeable selon la revendication 6, comprenant en outre un dispositif de commande (470) configuré pour :
recevoir la température intérieure du système de charge et décharge de batterie rechargeable, mesurée par le capteur (460) ; et
commander l'entraînement du refroidisseur (140, 340, 440).

8. Système de charge et décharge de batterie rechargeable selon la revendication 1, dans lequel la pluralité d'éléments de batterie (1, 2, 3, 4) logés dans le plateau (110, 210, 310, 410) sont agencés verticalement.

9. Système de charge et décharge de batterie rechargeable selon la revendication 1, dans lequel le plateau (110, 210, 310, 410) a une structure dans laquelle une surface latérale est ouverte, et
dans lequel le refroidisseur (140, 340, 440) inclut un sous-ventilateur de soufflage (142) configuré pour souffler de l'air refroidi d'une surface latérale du plateau (110, 210, 310, 410) vers la pluralité d'éléments de batterie (1, 2, 3, 4).

10. Procédé de commande de température d'un système de charge et décharge de batterie rechargeable qui utilise le système de charge et décharge de batterie rechargeable (100, 200, 300, 400) selon la revendication 1.

11. Procédé de commande de température selon la revendication 10, comprenant en outre la charge et la décharge d'un élément de batterie logé dans le plateau (110, 210, 310, 410),
dans lequel la charge et la décharge de l'élément de batterie consiste à :
mesurer une température intérieure du système de charge et décharge de batterie rechargeable (100, 200, 300, 400) ; et
commander, par un dispositif de commande (470), le refroidisseur (140, 340, 440) en fonction de la température intérieure mesurée du système de charge et décharge de batterie rechargeable (100, 200, 300, 400).
